# FASCICULE DE BREVET EUROPEEN

(11) **EP 3 891 813 B1**
(45) Date de publication et mention de la délivrance du brevet: **25.01.2023**
(21) Numéro de dépôt: 19839354.8
(22) Date de dépôt: 03.12.2019
(51) Int. Cl.: H01L 27/15, H01L 33/00

(54) **DISPOSITIF D'AFFICHAGE ÉLECTROLUMINESCENT MULTI-COULEURS ET PROCÉDÉ DE FABRICATION D'UN TEL DISPOSITIF**
MEHRFARBIGE ELEKTROLUMINESZIERENDE ANZEIGEVORRICHTUNG UND VERFAHREN ZUR HERSTELLUNG EINER SOLCHEN VORRICHTUNG
MULTICOLOUR ELECTROLUMINESCENT DISPLAY DEVICE AND METHOD OF MANUFACTURING THE SAME

(30) Priorité: 05.12.2018 FR 1872366
(43) Date de publication de la demande: 13.10.2021
(73) Titulaire: Commissariat à l'Energie Atomique et aux Energies Alternatives, 75015 Paris (FR)
(72) Inventeur: CHARLES, Matthew, 38054 GRENOBLE CEDEX 9 (FR)
(74) Mandataire: Cabinet Beaumont
(86) Numéro de dépôt international: PCT/FR2019/052907
(87) Numéro de publication internationale: WO 2020/115426

(56) Documents cités:
- EP-A1- 2 636 078
- EP-A1- 2 636 078
- US-A1- 2003 141 512
- US-A1- 2003 141 512
- POLYAKOV A ET AL: "Properties of undoped GaN/InGaN multi-quantum-wells and GaN/InGaN p-n junctions prepared by epitaxial lateral overgrowth", JOURNAL OF APPLIED PHYSICS, AMERICAN INSTITUTE OF PHYSICS, US, vol. 105, no. 12, 23 juin 2009 (2009-06-23), pages 123708-123708, XP012125707, ISSN: 0021-8979, DOI: 10.1063/1.3153967
- POLYAKOV A ET AL: "Properties of undoped GaN/InGaN multi-quantum-wells and GaN/InGaN p-n junctions prepared by epitaxial lateral overgrowth", JOURNAL OF APPLIED PHYSICS, AMERICAN INSTITUTE OF PHYSICS, 2 HUNTINGTON QUADRANGLE, MELVILLE, NY 11747, vol. 105, no. 12, 23 June 2009 (2009-06-23), pages 123708-123708, XP012125707, ISSN: 0021-8979, DOI: 10.1063/1.3153967

## Description

La présente demande de brevet revendique la priorité de la demande de brevet français FR18/72366.

### Domaine technique

La présente description concerne de façon générale les dispositifs électroluminescents à base de matériaux semiconducteurs et leurs procédés de fabrication. Elle vise plus particulièrement la réalisation d'un dispositif d'affichage électroluminescent multi-couleurs, c'est-à-dire comportant une pluralité de pixels parmi lesquels des pixels de types différents sont respectivement adaptés à émettre de la lumière dans des gammes de longueurs d'ondes différentes.

### Technique antérieure

Un dispositif d'affichage électroluminescent comprend classiquement une pluralité de pixels, chaque pixel étant commandable individuellement pour convertir un signal électrique en un rayonnement lumineux. Plus particulièrement, chaque pixel comprend une cellule électroluminescente comportant un empilement d'une première couche semiconductrice dopée d'un premier type de conductivité, d'une couche active, et d'une deuxième couche semiconductrice dopée du deuxième type de conductivité. En fonctionnement, un courant électrique est appliqué entre les première et deuxième couches semiconductrices de la cellule. Sous l'effet de ce courant, la couche active émet un rayonnement lumineux dans une gamme de longueurs d'ondes qui dépend essentiellement de sa composition. Chaque pixel peut de plus comprendre un circuit de contrôle, comprenant par exemple un ou plusieurs transistors, permettant de contrôler l'intensité du courant appliqué à la cellule électroluminescente du pixel, et par conséquent l'intensité du rayonnement lumineux émis par le pixel.

Pour permettre l'affichage d'images multi-couleurs, il convient que le dispositif d'affichage comprenne plusieurs pixels de types différents adaptés à émettre respectivement dans des gammes de longueurs d'ondes différentes.

Pour réaliser un dispositif d'affichage multi-couleurs, une possibilité est de reporter sur un même substrat des pixels réalisés séparément à base de matériaux semiconducteurs différents. La fixation et l'alignement des pixels sur le substrat de report peuvent toutefois être délicats à réaliser. En particulier, cette technique n'est pas adaptée à la réalisation de dispositifs d'affichage ayant un pas inter-pixels faible, par exemple inférieur à 10 µm.

Une autre possibilité est de réaliser un dispositif d'affichage dans lequel les cellules électroluminescentes des pixels émettent toutes dans la même gamme de longueurs d'ondes, les cellules électroluminescentes de certains pixels étant revêtues d'une couche de conversion de couleur, par exemple une couche incorporant des boîtes quantiques ou des nano-phosphores, adaptée à convertir le rayonnement lumineux émis par la cellule électroluminescente en un rayonnement lumineux dans une autre gamme de longueurs d'ondes. Le dépôt localisé de couches de conversion de couleur peut toutefois être délicat à réaliser. De plus, la tenue dans le temps de certains matériaux de conversion est relativement limitée.

Une autre possibilité est de réaliser successivement les cellules électroluminescentes des pixels de types différents, lors de séquences d'épitaxie localisée distinctes, en modifiant à chaque séquence la composition des couches déposées de façon à obtenir des pixels à émission directe dans des gammes de longueurs d'ondes distinctes. Un inconvénient de cette méthode réside toutefois dans son coût élevé, lié à la mise en oeuvre de plusieurs séquences d'épitaxie successives pour réaliser successivement les cellules électroluminescentes des différents types de pixels.

EP 2 636 078 A1 divulgue un dispositif optoélectronique monolithique, comprenant différentes cellules émettant des longueurs d'onde différentes et contrôlables indépendamment, dans lequel chaque cellule comprend une couche semi-conductrice crûe au travers des ouvertures d'un masque et coalescée au-dessus de ce masque, la longueur d'onde émise par chaque cellule étant définie en variant la dimension et/ou l'espacement des ouvertures du masque dans ladite cellule.

### Résumé de l'invention

Il existe un besoin pour un dispositif d'affichage électroluminescent multi-couleurs et pour un procédé de fabrication d'un tel dispositif, palliant tout ou partie des inconvénients des solutions connues.

Ainsi, un mode de réalisation prévoit un dispositif électroluminescent comportant des première et deuxième cellules électroluminescentes adaptées à émettre respectivement dans des première et deuxième gammes de longueurs d'ondes, dans lequel :
- chaque cellule électroluminescente comporte un empilement d'une première couche d'un premier matériau semiconducteur et d'une deuxième couche d'un deuxième matériau semiconducteur ayant un paramètre de maille différent de celui du premier matériau ;
- dans la première cellule, la première couche est en contact avec la deuxième couche sur sensiblement toute la surface de la cellule ; et
- dans la deuxième cellule, un masque muni d'une pluralité de nano-ouvertures traversantes régulièrement réparties sur toute la surface de la cellule fait interface entre la première couche et la deuxième couche, la deuxième couche comportant une pluralité de nano-piliers du deuxième matériau disposés dans les nano-ouvertures du masque, en contact, par une première face, avec la première couche, et une couche coalescée du deuxième matériau en contact avec une deuxième face des nano-piliers opposée à la première couche, s'étendant sur sensiblement toute la surface de la cellule du côté du masque opposé à la première couche.

Selon un mode de réalisation, dans chaque cellule, la première couche est dopée d'un premier type de conductivité, la deuxième couche est surmontée d'une couche active, et la couche active est surmontée d'une couche semiconductrice dopée du deuxième type de conductivité.

Selon un mode de réalisation, la première couche est en nitrure de gallium et la deuxième couche est en nitrure de gallium-indium.

Selon un mode de réalisation, le dispositif comprend une troisième cellule électroluminescente identique à la première cellule, dans lequel la troisième cellule est surmontée d'un élément de conversion de longueur d'onde, les première et deuxième cellules n'étant pas surmontées d'éléments de conversion de longueur d'onde.

Selon un mode de réalisation, le dispositif comprend en outre une troisième cellule électroluminescente adaptée à émettre dans une troisième gamme de longueurs d'ondes, dans lequel :
- la troisième cellule électroluminescente comporte un empilement d'une première couche du premier matériau semiconducteur et d'une deuxième couche du deuxième matériau semiconducteur ;
- dans la troisième cellule, un masque muni d'une pluralité de nano-ouvertures traversantes régulièrement réparties sur toute la surface de la cellule fait interface entre la première couche et la deuxième couche ;
- l'épaisseur du masque est plus importante dans la troisième cellule que dans la deuxième cellule ; et
- l'épaisseur de la deuxième couche est supérieure à l'épaisseur du masque dans la deuxième cellule et inférieure à l'épaisseur du masque dans la troisième cellule.

Selon un mode de réalisation, chaque cellule comporte en outre une troisième couche d'un troisième matériau semiconducteur surmontant la deuxième couche, dans lequel :
- dans chacune des première et deuxième cellules, la troisième couche est en contact avec la deuxième couche sur sensiblement toute la surface de la cellule ; et
- dans la troisième cellule, la troisième couche comporte une pluralité de nano-piliers disposés dans les nano-ouvertures du masque, en contact, par une première face, avec la deuxième couche, et une couche coalescée du matériau de la troisième couche en contact avec une deuxième face des nano-piliers opposée à la deuxième couche, s'étendant sur sensiblement toute la surface de la cellule du côté du masque opposé à la première couche.

Selon un mode de réalisation, le troisième matériau présente une différence de paramètre de maille avec le deuxième matériau, la différence de paramètre de maille entre le deuxième matériau et le troisième matériau étant plus importante que la différence de paramètre de maille entre le premier matériau et le troisième matériau.

Selon un mode de réalisation, les première, deuxième et troisième couches sont respectivement en nitrure de gallium, en nitrure de gallium-aluminium et en nitrure de gallium-indium.

Selon un mode de réalisation, les première, deuxième et troisième couches sont respectivement en nitrure de gallium, en nitrure de gallium-indium et en nitrure de gallium-indium, les compositions des deuxième et troisième couches de nitrure de gallium-indium étant différentes.

Selon un mode de réalisation, le dispositif comprend en outre une troisième cellule électroluminescente adaptée à émettre dans une troisième gamme de longueurs d'ondes, dans lequel :
- la troisième cellule électroluminescente comporte un empilement d'une première couche du premier matériau semiconducteur et d'une deuxième couche du deuxième matériau semiconducteur ;
- dans la troisième cellule, un masque muni d'une pluralité de nano-ouvertures traversantes régulièrement réparties sur toute la surface de la cellule fait interface entre la première couche et la deuxième couche ; et
- les dimensions des nano-ouvertures du masque sont plus importantes dans la troisième cellule que dans la première cellule.

Un autre mode de réalisation prévoit un procédé de fabrication d'un dispositif tel que défini ci-dessus, dans lequel les deuxièmes couches des différentes cellules sont formées simultanément lors d'une même étape d'épitaxie.

Selon un mode de réalisation, les couches actives des différentes cellules sont formées simultanément lors d'une même étape d'épitaxie.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre une étape d'un procédé de fabrication d'un dispositif d'affichage électroluminescent selon un premier mode de réalisation ;
la figure 2 illustre une autre étape d'un procédé de fabrication d'un dispositif d'affichage électroluminescent selon le premier mode de réalisation ;
la figure 3 illustre une autre étape d'un procédé de fabrication d'un dispositif d'affichage électroluminescent selon le premier mode de réalisation ;
la figure 4 illustre une autre étape d'un procédé de fabrication d'un dispositif d'affichage électroluminescent selon le premier mode de réalisation ;
la figure 5 illustre une autre étape d'un procédé de fabrication d'un dispositif d'affichage électroluminescent selon le premier mode de réalisation ;
la figure 6 illustre une autre étape d'un procédé de fabrication d'un dispositif d'affichage électroluminescent selon le premier mode de réalisation ;
la figure 7 illustre une étape d'un procédé de fabrication d'un dispositif d'affichage électroluminescent selon un deuxième mode de réalisation ;
la figure 8 illustre une autre étape d'un procédé de fabrication d'un dispositif d'affichage électroluminescent selon le deuxième mode de réalisation ;
la figure 9 illustre une autre étape d'un procédé de fabrication d'un dispositif d'affichage électroluminescent selon le deuxième mode de réalisation ;
la figure 10 illustre une autre étape d'un procédé de fabrication d'un dispositif d'affichage électroluminescent selon le deuxième mode de réalisation ;
la figure 11 illustre une autre étape d'un procédé de fabrication d'un dispositif d'affichage électroluminescent selon le deuxième mode de réalisation ;
la figure 12 illustre un procédé de fabrication d'un dispositif d'affichage électroluminescent selon un troisième mode de réalisation ; et
la figure 13 illustre un procédé de fabrication d'un dispositif d'affichage électroluminescent selon un quatrième mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, on s'intéresse ici plus spécifiquement à la réalisation des cellules électroluminescentes des pixels d'un dispositif d'affichage électroluminescent multi-couleurs. La réalisation des circuits de contrôle des pixels et d'éventuelles structures d'isolation entre les cellules électroluminescentes des pixels et/ou de connexion des cellules électroluminescentes aux circuits de contrôle des pixels, n'a pas été détaillée, les modes de réalisation décrits étant compatibles avec les réalisations usuelles de ces éléments.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures, étant entendu que, en pratique, les dispositifs décrits peuvent être orientés différemment.

Sauf précision contraire, les expressions "environ", "approximativement", "sensiblement", et "de l'ordre de" signifient à 10 % près, de préférence à 5 % près.

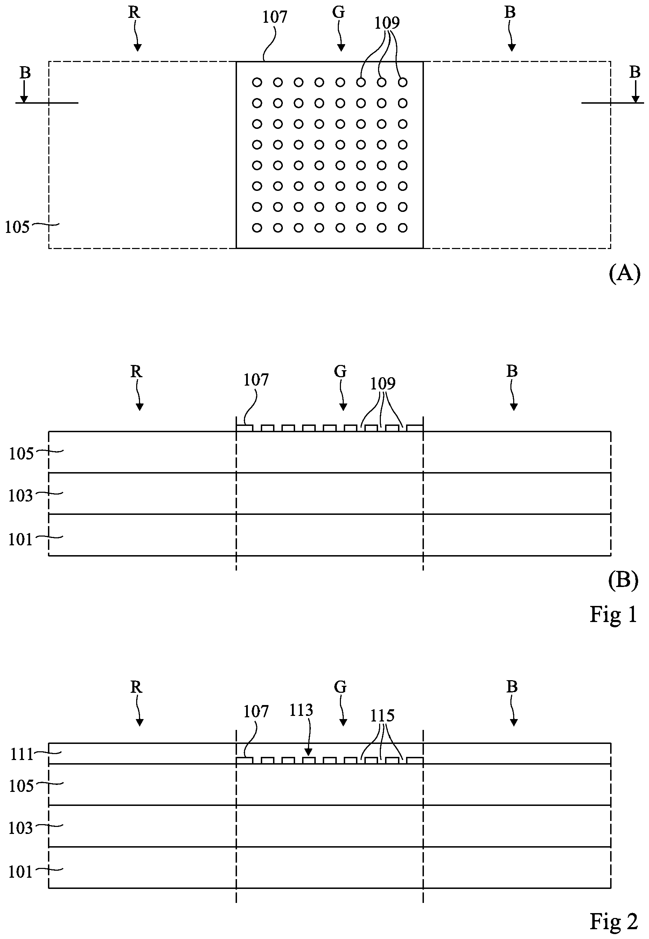

Les figures 1 à 6 illustrent des étapes successives d'un exemple d'un procédé de fabrication d'un dispositif d'affichage électroluminescent multi-couleurs selon un premier mode de réalisation.

On considère ici, à titre d'exemple, la réalisation d'un dispositif d'affichage comportant trois types de pixels différents, adaptés à émettre respectivement dans trois gammes de longueurs d'ondes distinctes. Plus particulièrement, on cherche dans cet exemple à réaliser un dispositif d'affichage comportant un ou plusieurs pixels d'un premier type, appelés pixels bleus, adaptés à émettre majoritairement de la lumière bleue, par exemple dans une gamme de longueurs d'ondes comprise entre 400 et 490 nm, un ou plusieurs pixels d'un deuxième type, appelés pixels verts, adaptés à émettre majoritairement de la lumière verte, par exemple dans une gamme de longueurs d'ondes comprise entre 490 et 570 nm, et un ou plusieurs pixels d'un troisième type, appelés pixels rouges, adaptés à émettre majoritairement de la lumière rouge, par exemple dans une gamme de longueurs d'ondes comprise entre 570 et 710 nm. Sur les figures 1 à 6, un unique pixel bleu B, un unique pixel vert G et un unique pixel rouge R sont représentés, étant entendu que, en pratique, le dispositif d'affichage peut comporter plusieurs pixels de chaque type, les pixels d'un même type étant identiques ou similaires aux dispersions de fabrication près. A titre d'exemple, les cellules électroluminescentes des pixels R, G et B ont, vues de dessus, la même forme générale, par exemple une forme carrée ou rectangulaire, et les mêmes dimensions latérales, par exemple comprises entre 1 et 20 µm, et de préférence entre 5 et 10 µm. Les modes de réalisation décrits ne se limitent toutefois pas à ce cas particulier.

Dans cet exemple, dans chaque pixel, la couche active de la cellule électroluminescente du pixel comprend des moyens de confinement correspondant à des puits quantiques multiples. Plus particulièrement, la couche active comprend une alternance de couches semiconductrices d'un premier matériau et de couches semiconductrices d'un deuxième matériau, chaque couche du premier matériau étant prise en sandwich entre deux couches du deuxième matériau, le premier matériau ayant une bande interdite plus étroite que celle du deuxième matériau.

A titre d'exemple, chacun des premier et deuxième matériaux comprend majoritairement un composé III-V comprenant au moins un premier élément du groupe III, un deuxième élément du groupe V, et, éventuellement, un troisième élément, par exemple un élément du groupe III autre que le premier élément.

Des exemples d'éléments du groupe III comprennent le gallium (Ga), l'indium (In) ou l'aluminium (Al). Des exemples d'éléments du groupe V comprennent l'azote, le phosphore ou l'arsenic. Des exemples de composés III-V binaires et ternaires sont le GaN, l'AlN, l'InN, l'InGaN, l'AlGaN ou l'AlInGaN. De façon générale, les éléments dans le composé III-V peuvent être combinés avec différentes fractions molaires.

Dans un mode de réalisation préféré, le premier matériau est de l'InGaN et le deuxième matériau est du GaN ou de l'InGaN ayant une concentration d'indium inférieure à celle du premier matériau.

Selon un aspect d'un mode de réalisation, on prévoit de réaliser simultanément les cellules électroluminescentes des trois types de pixels, lors d'une même séquence d'étapes d'épitaxie.

La figure 1 comprend une vue (A) de dessus et une vue (B) en coupe selon le plan B-B de la vue (A) d'une structure de départ comportant un substrat de croissance 101, par exemple en saphir (Al₂O₃), en carbure de silicium (SiC), en silicium (Si), en nitrure de gallium (GaN) ou en nitrure d'aluminium (AlN), un empilement 103 d'une ou plusieurs couches tampon sur et en contact avec la face supérieure du substrat de croissance 101, et une couche cristalline de nitrure de gallium (GaN) 105 dopée de type N sur et en contact avec la face supérieure de l'empilement 103. A titre d'exemple, l'empilement de couches tampon 103 est formé par épitaxie sur la face supérieure du substrat 101, et la couche 105 est formée par épitaxie sur la face supérieure de l'empilement 103. Dans cet exemple, l'empilement 103 s'étend de façon continue et présente une épaisseur sensiblement uniforme sur toute la surface supérieure du substrat 101, et la couche 105 s'étend de façon continue et présente une épaisseur sensiblement uniforme sur toute la surface supérieure de l'empilement 103. L'épaisseur de l'empilement 103 est par exemple comprise entre 0,5 et 10 µm. L'épaisseur de la couche 105 est par exemple comprise entre 0,5 et 10 µm.

La figure 1 illustre plus particulièrement une étape de formation d'un masque 107 sur la face supérieure de la couche 103. Le masque est par exemple en un matériau diélectrique, par exemple en nitrure de silicium ou en oxyde de silicium. Dans cet exemple, le masque 107 est localisé en regard des seuls pixels verts G du dispositif, c'est-à-dire qu'il ne recouvre pas les cellules électroluminescentes des pixels rouges R ni les cellules électroluminescentes des pixels bleus B du dispositif. En regard de chaque pixel vert G, le masque 107 comprend une pluralité de nano-ouvertures traversantes 109, identiques ou similaires, par exemple de forme cylindrique, régulièrement réparties sur toute la surface de la cellule électroluminescente du pixel. Par nano-ouvertures on entend ici des ouvertures ayant des dimensions latérales (largeur ou diamètre) inférieures au micromètre. Par traversantes, on entend ici que les ouvertures 109 traversent verticalement de part en part le masque 107. A titre d'exemple, chacune des ouvertures 109 a une dimension latérale (largeur ou diamètre) comprise entre 10 et 100 nm, de préférence entre 20 et 50 nm. Le pas de répétition des ouvertures 109 (distance centre à centre entre deux ouvertures voisines en vue de dessus) est par exemple inférieur à 200 nm, de préférence inférieur à 100 nm, par exemple compris entre 20 et 80 nm. A titre d'exemple, les ouvertures 109 ont chacune une dimension latérale de l'ordre de 25 nm, et le pas de répétition des ouvertures est de l'ordre de 40 nm. L'épaisseur du masque 107 est par exemple comprise entre 10 et 100 nm, de préférence entre 10 et 30 nm, par exemple de l'ordre de 20 nm. Dans l'exemple représenté, le masque 107 a, vu de dessus, une forme générale carrée et présente une symétrie carrée. Les modes de réalisation décrits ne se limitent pas à cet exemple particulier. A titre de variante, le masque 107 peut avoir, vu de dessus, une forme générale hexagonale et présenter une symétrie hexagonale.

Dans un mode de réalisation préféré, pour former les ouvertures 109 du masque 107, un film (non représenté) de porosité contrôlée à base de copolymères à blocs est déposé sur la face supérieure d'une couche continue du matériau de masquage, puis le masque 107 est gravé en regard des pores du film de copolymères pour former les ouvertures 109. Le film de copolymère sert ainsi de masque pour la gravure des ouvertures 109. Une fois la gravure des ouvertures 109 réalisée, le film de copolymère peut être retiré. Un exemple de mise en oeuvre d'un tel procédé est par exemple décrit dans l'article intitulé "Density Multiplication and Improved Lithography by Directed Block Copolymer Assembly" de Ricardo Ruiz et al (Science 15 Aug 2008: Vol. 321, Issue 5891, pp. 936-939). Un avantage d'un tel procédé est qu'il permet de former rapidement un grand nombre d'ouvertures 109 de petites dimensions espacées dans le masque 107.

A titre de variante, les ouvertures 109 du masque 107 sont formées par lithographie par faisceau d'électrons.

A titre d'exemple, la formation du masque 107 peut comprendre une étape de dépôt d'une couche du matériau de masquage s'étendant de façon continue sur toute la surface du dispositif, suivie d'une étape de formation, dans le matériau de masquage, d'ouvertures 109 régulièrement réparties sur toute la surface du dispositif, suivie d'une étape de retrait localisé du masque de façon à conserver le masque uniquement en regard des pixels verts G du dispositif.

La figure 2 est une vue en coupe dans le même plan que la vue (B) de la figure 1, illustrant une étape de dépôt, par épitaxie, d'une couche 111 d'un matériau semiconducteur dopé de type N sur la face supérieure de la structure obtenue à l'issue des étapes de la figure 1. Lors de cette étape, la croissance épitaxiale s'opère à partir des portions non masquées de la face supérieure de la couche 105. Ainsi, dans les pixels rouges R et bleus B, la croissance épitaxiale s'opère de façon uniforme sur toute la surface des cellules électroluminescentes des pixels, et, dans les pixels verts G, la croissance épitaxiale s'opère uniquement à partir des portions de la face supérieure de la couche 105 situées au fond des ouvertures 109 du masque 107. L'épitaxie est réalisée de manière simultanée dans tous les pixels du dispositif. L'épitaxie est par exemple effectuée par MOCVD (de l'anglais "MetalOrganic Chemical Vapor Deposition" - épitaxie en phase vapeur aux organométalliques) ou par MBE (de l'anglais "Molecular Beam Epitaxy" - épitaxie par jet moléculaire).

La couche 111 est déposée sur une épaisseur supérieure à l'épaisseur du masque 107, de façon que, en regard de chaque pixel vert G, la couche 111 comprenne, en partie supérieure, une couche coalescée 113 s'étendant de façon continue sur toute la surface de la cellule électroluminescente du pixel. A titre d'exemple, l'épaisseur de la couche 111 à l'issue de l'étape de dépôt de la figure 2 est comprise entre 20 et 100 nm. A l'issue de l'étape de dépôt de la figure 2, dans chaque pixel rouge R ou bleu B du dispositif, la couche 111 est une couche sensiblement plane s'étendant de façon continue et sur une épaisseur sensiblement uniforme sur toute la surface de la cellule électroluminescente du pixel, et, dans chaque pixel vert G du dispositif, la couche 111 comprend :
- une partie inférieure constituée de nano-piliers 115 du matériau semiconducteur, remplissant les ouvertures 109 du masque 107, chaque nano-pilier 115 étant en contact, par sa face inférieure, avec la couche 105 ; et
- une partie supérieure constituée par la couche coalescée 113 du matériau semiconducteur, la couche 113 étant sensiblement plane et s'étendant de façon continue et sur une épaisseur sensiblement uniforme sur toute la surface de la cellule électroluminescente du pixel, et étant en contact, par sa face inférieure, avec la face supérieure des nano-piliers 115 et avec la face supérieure du masque 107.

Le matériau semiconducteur de la couche 111 présente un paramètre de maille différent de celui de la couche 105. Dans cet exemple, la couche 105 est en nitrure de gallium (GaN) et la couche 111 est en nitrure de gallium-indium (InGaN). Du fait de la différence de paramètre de maille entre les matériaux des couches 105 et 111, et du fait de l'épaisseur relativement faible de la couche 111 par rapport à la couche 105, la couche 111 est, du côté de sa face supérieure, relativement fortement contrainte en regard des pixels rouges R et bleus B du dispositif. Dans les pixels verts G du dispositif, du fait de la présence de nanostructurations du côté de la face inférieure de la couche 111, à l'interface avec la couche 105, la couche 111 est en revanche relativement faiblement contrainte voire relaxée du côté de sa face supérieure.

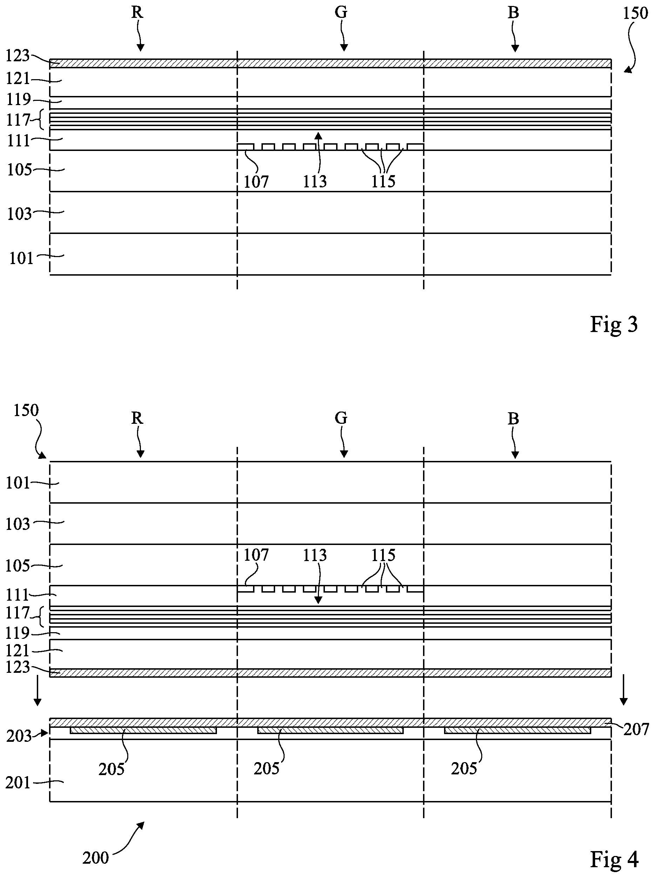

La figure 3 est une vue en coupe dans le même plan que la vue (B) de la figure 2, illustrant une étape de dépôt, par épitaxie, d'une couche active 117 dans les pixels rouges R, verts G et bleus B du dispositif. Lors de cette étape, la croissance épitaxiale s'opère à partir de la face supérieure de la couche 111. L'épitaxie est réalisée de manière simultanée dans tous les pixels du dispositif. L'épitaxie est par exemple réalisée par MOCVD. Lors de cette étape, on dépose une alternance de couches semiconductrices d'un premier matériau, par exemple de l'InGaN, et de couches semiconductrices d'un deuxième matériau ayant une bande interdite plus large que celle du premier matériau, par exemple du GaN ou de l'InGaN ayant une concentration d'indium inférieure à celle du premier matériau, de façon à former un empilement de puits quantiques, par exemple un empilement de 3 à 10 puits quantiques. A titre d'exemple, l'épaisseur totale de la couche active 117 est comprise entre 40 et 150 nm. Dans chaque pixel du dispositif, la couche active 117 est une couche sensiblement plane s'étendant de façon continue et sur une épaisseur sensiblement uniforme sur toute la surface de la cellule électroluminescente du pixel. L'épaisseur de la couche active 117 est par exemple sensiblement la même dans tous les pixels du dispositif. Toutefois, du fait des différences de contrainte en partie supérieure de la couche 111 entre les pixels rouges R et bleus B d'une part et les pixels verts G d'autre part, la concentration d'indium dans chaque couche d'InGaN de la couche active 117 n'est pas la même dans les pixels R et B que dans les pixels G. Plus particulièrement, on obtient une concentration d'indium moins importante dans les pixels R et B que dans les pixels G. Cette différence de concentration vient du fait que, lors d'une seule et unique étape d'épitaxie, l'indium s'incorpore plus facilement dans une couche relativement faiblement contrainte voire relaxée que dans une couche relativement fortement contrainte. Ceci permet d'obtenir des gammes de longueurs d'ondes d'émission différentes dans les cellules électroluminescentes des pixels R et B d'une part, et dans les cellules électroluminescentes des pixels G d'autre part. Plus particulièrement dans cet exemple, les conditions de croissance de la couche active 117 sont choisies de façon à obtenir une émission majoritairement dans le bleu dans les cellules électroluminescentes des pixels R et B, et une émission majoritairement dans le vert dans les cellules électroluminescentes des pixels G.

La figure 3 illustre en outre une étape optionnelle de dépôt, dans chaque pixel, d'une couche 119 formant une barrière à électrons sur et en contact avec la face supérieure de la couche active 117. La couche 119 est par exemple une couche de nitrure d'aluminium-gallium (AlGaN) dopée de type P. La couche 119 peut être déposée simultanément dans tous les pixels du dispositif. Dans chaque pixel du dispositif, la couche 119 est une couche sensiblement plane s'étendant de façon continue et sur une épaisseur sensiblement uniforme sur toute la surface de la cellule électroluminescente du pixel. L'épaisseur de la couche 119 est par exemple sensiblement la même dans tous les pixels du dispositif, par exemple comprise entre 10 et 50 nm, par exemple de l'ordre de 20 nm.

La figure 3 illustre de plus une étape de dépôt d'une couche 121 d'un matériau semiconducteur dopé de type P sur et en contact avec la face supérieure de la couche barrière 119. La couche 121 est par exemple une couche de nitrure de gallium (GaN) dopée de type P. La couche 121 peut être déposée simultanément dans tous les pixels du dispositif. Dans chaque pixel du dispositif, la couche 121 est une couche sensiblement plane s'étendant de façon continue et sur une épaisseur sensiblement uniforme sur toute la surface de la cellule électroluminescente du pixel. L'épaisseur de la couche 121 est par exemple sensiblement la même dans tous les pixels du dispositif, par exemple comprise entre 100 et 300 nm.

La figure 3 illustre par ailleurs une étape de dépôt, dans chaque pixel, d'une couche conductrice 123 sur et en contact avec la face supérieure de la couche de type P 121. La couche 123 peut être déposée simultanément dans tous les pixels du dispositif. Dans chaque pixel du dispositif, la couche 123 est par exemple une couche sensiblement plane s'étendant de façon continue et sur une épaisseur sensiblement uniforme sur toute la surface de la cellule électroluminescente du pixel. L'épaisseur de la couche 123 est par exemple sensiblement la même dans tous les pixels du dispositif. Dans cet exemple, la couche 123 est une couche métallique s'étendant de façon continue sur sensiblement toute la surface supérieure du dispositif obtenu à l'issue des étapes précédentes.

La figure 4 illustre une étape de report de la structure 150 obtenue à l'issue des étapes des figures 1 à 3 sur un circuit intégré 200 comprenant, pour chaque pixel du dispositif, un circuit de contrôle élémentaire, par exemple à base de transistors MOS, permettant de contrôler individuellement le courant circulant dans la cellule électroluminescente du pixel, et par conséquent l'intensité lumineuse émise par la cellule. On notera que sur la figure 4, la structure 150 est retournée par rapport à l'orientation de la figure 3.

Le circuit intégré 200 est formé dans et sur un substrat semiconducteur 201, par exemple en silicium, par exemple en technologie CMOS. Dans cet exemple, le circuit intégré 200 comprend un empilement 203 de couches isolantes et conductrices d'interconnexion revêtant la face supérieure du substrat 201. L'empilement d'interconnexion 203 comprend notamment, pour chaque pixel, un plot de connexion métallique 205 affleurant la face supérieur de l'empilement 203, connecté au circuit de contrôle élémentaire du pixel. Dans cet exemple, le circuit intégré 200 comprend en outre une couche métallique 207 s'étendant de façon continue sur sensiblement toute la surface supérieure de l'empilement d'interconnexion 203.

Lors de l'étape de report de la figure 4, la face inférieure (selon l'orientation de la figure 4) de la couche métallique 123 de la structure 150 est mise en contact avec la face supérieure de la couche métallique 207 du circuit 200. La structure 150 et le circuit 200 sont par exemple fixés l'un à l'autre par collage direct ou collage moléculaire de la couche métallique 123 sur la couche métallique 207.

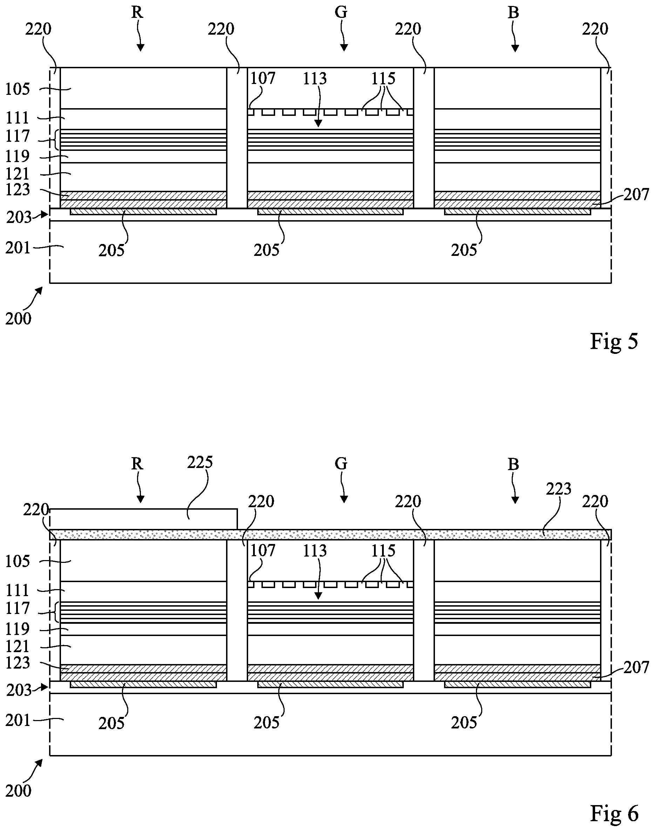

La figure 5 illustre une étape postérieure au report de la structure 150 sur le circuit de contrôle 200, au-cours de laquelle le substrat de croissance 101 et l'empilement de couches tampon 103 de la structure 150 sont retirés de façon à libérer l'accès à la face supérieure (c'est-à-dire la face opposée au circuit de contrôle 200) de la couche 105.

La figure 5 illustre en outre une étape, postérieure au retrait du substrat 101 et de l'empilement 103, de formation de tranchées 220 isolant les unes des autres les cellules électroluminescentes des différents pixels du dispositif. Dans cet exemple, les tranchées 220 s'étendent verticalement depuis la face supérieure de la couche 105 jusqu'à la face supérieure de l'empilement d'interconnexion 203. Les tranchées 220 peuvent être remplies totalement ou partiellement d'un matériau électriquement isolant, par exemple de l'oxyde de silicium.

La figure 6 illustre une étape ultérieure de dépôt d'une couche conductrice 223 sur la face supérieure de la structure obtenue à l'issue des étapes des figures 1 à 5. Dans cet exemple, la couche 223 est une couche conductrice transparente, par exemple en oxyde d'indium-étain (ITO), s'étendant de façon continue sur sensiblement toute la surface du dispositif. La couche 223 est notamment en contact, dans chaque pixel, avec la face supérieure de la couche semiconductrice de type N 105 de la cellule électroluminescente du pixel. Dans cet exemple, la couche 223 permet de prendre un contact collectif sur les couches 105 de toutes les cellules électroluminescente du dispositif, un contact individuel étant pris sur la couche semiconductrice de type P 121 de chaque cellule par l'intermédiaire des plots 205 et des couches métalliques 207 et 123.

La figure 6 illustre de plus une étape de dépôt ou report localisé, en regard de chaque pixel rouge R du dispositif, sur la face supérieure de la couche conductrice transparente 223, d'un élément de conversion de couleur 225 adapté à convertir le rayonnement lumineux émis par la cellule électroluminescente du pixel R en un rayonnement lumineux dans une autre gamme de longueur d'onde. Dans cet exemple, l'élément 225 est adapté à convertir la lumière bleue émise par la cellule électroluminescente du pixel R en lumière rouge. L'élément 225 est par exemple constitué d'une couche incorporant des boîtes quantiques ou des nano-phosphores.

Un avantage du procédé de fabrication décrit en relation avec les figures 1 à 6 est qu'il permet de réaliser simultanément, lors d'une même séquence d'étapes d'épitaxie deux types de cellules électroluminescentes adaptées à émettre respectivement dans deux bandes de longueurs d'ondes distinctes. Ceci permet notamment de réduire le nombre d'éléments de conversion de couleur de types différents à prévoir pour réaliser un dispositif d'affichage multi-couleurs. En particulier, dans l'exemple décrit ci-dessus, un unique type d'élément de conversion de couleur est suffisant pour réaliser un dispositif d'affichage à trois couleurs, ce qui réduit la complexité du dispositif.

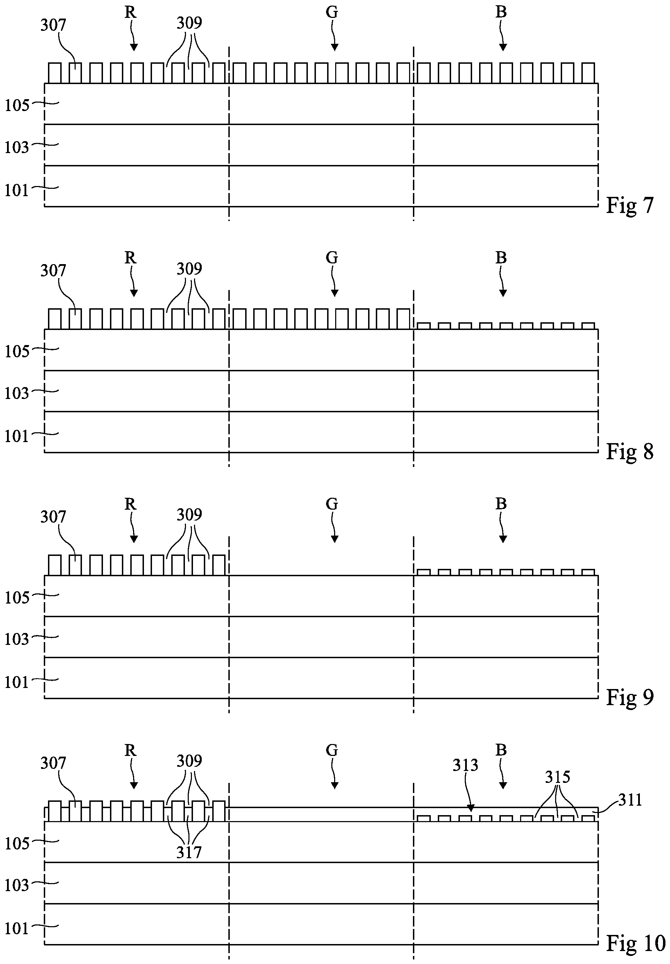

Les figures 7 à 11 sont des vues en coupe illustrant des étapes successives d'un exemple d'un procédé de fabrication d'un dispositif d'affichage électroluminescent multi-couleurs selon un deuxième mode de réalisation.

On considère ici, comme dans l'exemple des figures 1 à 6, la réalisation d'un dispositif d'affichage comportant trois types de pixels différents, adaptés à émettre respectivement dans trois gammes de longueurs d'ondes distinctes. Plus particulièrement, on cherche ici, comme dans l'exemple des figures 1 à 6, à réaliser un dispositif d'affichage comportant un ou plusieurs pixels bleus B, adaptés à émettre majoritairement de la lumière bleue, un ou plusieurs pixels verts G, adaptés à émettre majoritairement de la lumière verte, et un ou plusieurs pixels rouges R, adaptés à émettre majoritairement de la lumière rouge.

La figure 7 représente une structure de départ identique ou similaire à la structure de la figure 1, comportant un substrat de croissance 101, un empilement 103 d'une ou plusieurs couches tampon sur et en contact avec la face supérieure du substrat de croissance 101, et une couche de nitrure de gallium (GaN) 105 dopée de type N sur et en contact avec la face supérieure de l'empilement 103.

La figure 7 illustre plus particulièrement une étape de formation d'un masque 307 sur la face supérieure de la couche 103. Le masque 307 est par exemple en un matériau diélectrique, par exemple en nitrure de silicium ou en oxyde de silicium. Le masque 307 est par exemple identique ou similaire au masque 107 de la figure 1, à ceci près que, dans l'exemple de la figure 7, le masque 307 s'étend sur tous les pixels R, G et B du dispositif, et non pas seulement en regard des pixels verts G. Le masque 307 comprend une pluralité de nano-ouvertures traversantes 309, par exemple identiques ou similaires aux ouvertures 109 du masque 107 de la figure 1, régulièrement réparties sur toute la surface du dispositif.

La figure 8 illustre une étape d'amincissement localisé du masque 307 en vis-à-vis des pixels bleus B du dispositif. A titre d'exemple, l'amincissement du masque 307 est réalisé par gravure anisotrope verticale localisée. A l'issue de cette étape, l'épaisseur du masque 307 en vis-à-vis des pixels bleus B est par exemple inférieure d'au moins 10 nm à l'épaisseur du masque 307 en vis-à-vis des pixels R et G.

La figure 9 illustre une étape de retrait localisé du masque 307 en vis-à-vis des pixels verts G du dispositif de façon à conserver le masque uniquement en vis-à-vis des pixels rouges R et bleus B du dispositif.

La figure 10 illustre une étape de dépôt, par épitaxie, d'une couche 311 d'un matériau semiconducteur dopé de type N sur la face supérieure de la structure obtenue à l'issue des étapes des figures 7 à 9. Lors de cette étape, la croissance épitaxiale s'opère à partir des portions non masquées de la face supérieure de la couche 105. Ainsi, dans les pixels verts G, la croissance épitaxiale s'opère de façon uniforme sur toute la surface des cellules électroluminescentes des pixels, et, dans les pixels rouges R et bleus B, la croissance épitaxiale s'opère uniquement à partir des portions de la face supérieure de la couche 105 situées au fond des ouvertures 309 du masque 307. L'épitaxie est réalisée de manière simultanée dans tous les pixels du dispositif, lors d'une unique étape d'épitaxie. L'épitaxie est par exemple effectuée par MOCVD.

La couche 311 est déposée sur une épaisseur supérieure à l'épaisseur du masque 307 en vis-à-vis des pixels bleus B du dispositif, et inférieure à l'épaisseur du masque 307 en vis-à-vis des pixels rouges R. Ainsi, en regard de chaque pixel bleu B, la couche 311 comprend, en partie supérieure, une couche coalescée 313 s'étendant de façon continue sur toute la surface de la cellule électroluminescente du pixel, et, en partie inférieure, une pluralité de nano-piliers 315 disposés dans les ouvertures 309 du masque 307 et reliant la couche coalescée 313 à la face supérieure de la couche 105. Dans chaque pixel vert G du dispositif, la couche 311 est une couche sensiblement plane s'étendant de façon continue et sur une épaisseur sensiblement uniforme sur toute la surface de la cellule électroluminescente du pixel. Dans chaque pixel rouge R du dispositif, la couche 311 est une couche discontinue constituée de nano-piliers 317 disposés dans les ouvertures 309 du masque 307, s'étendant depuis la face supérieure de la couche 105 et remplissant seulement partiellement les ouvertures 309.

Le matériau semiconducteur de la couche 311 présente un paramètre de maille différent de celui de la couche 105. Dans cet exemple, la couche 105 est en nitrure de gallium (GaN) et la couche 311 est en nitrure de gallium-aluminium (AlGaN) . Du fait de la différence de paramètre de maille entre les matériaux des couches 105 et 311, et du fait de l'épaisseur relativement faible de la couche 311 par rapport à la couche 105, la couche 311 est, du côté de sa face supérieure, relativement fortement contrainte en tension en regard des pixels verts G du dispositif. Dans les pixels rouges R et bleus B du dispositif, du fait de la présence de nanostructurations du côté de la face inférieure de la couche 311, la couche 311 est en revanche relativement faiblement contrainte voire relaxée du côté de sa face supérieure.

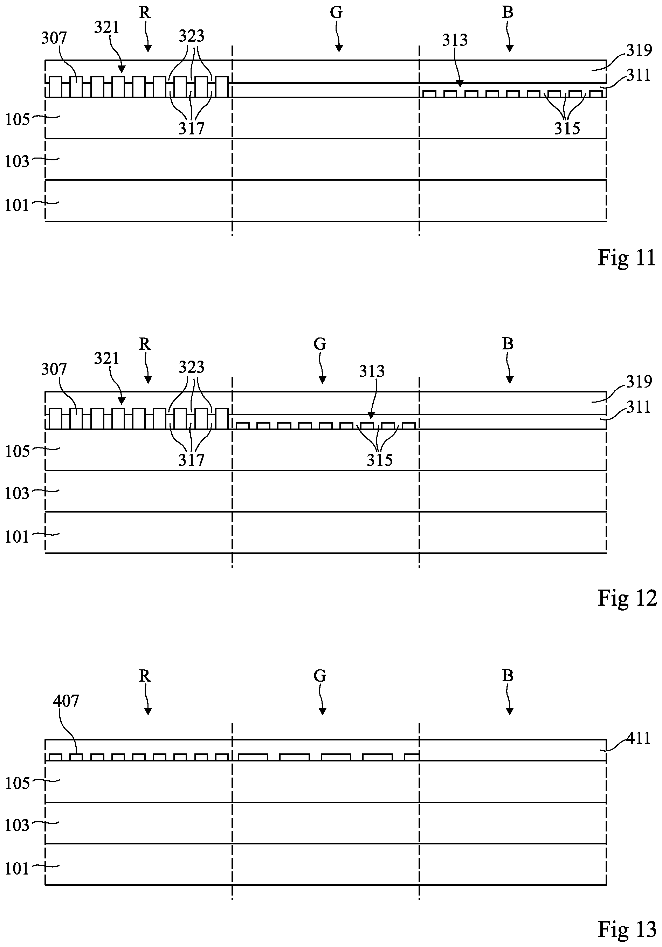

La figure 11 illustre une étape de dépôt, par épitaxie, d'une couche 319 d'un matériau semiconducteur dopé de type N sur la face supérieure de la structure obtenue à l'issue des étapes des figures 7 à 10. Lors de cette étape, la croissance épitaxiale s'opère à partir de la face supérieure de la couche 311. Ainsi, dans les pixels verts G et bleus B, la croissance épitaxiale s'opère de façon uniforme sur toute la surface des cellules électroluminescentes des pixels, et, dans les pixels rouges R, la croissance épitaxiale s'opère uniquement à partir de la face supérieure des nano-piliers 317 situés dans les ouvertures 309 du masque 307. L'épitaxie est réalisée de manière simultanée dans tous les pixels du dispositif. L'épitaxie est par exemple effectuée par MOCVD.

La couche 319 est déposée sur une épaisseur supérieure à la hauteur des portions des cavités 309 du masque 307 non comblées par les nano-piliers 317 dans les pixels rouges R du dispositif. Ainsi, en regard de chaque pixel rouge R, la couche 319 comprend, en partie supérieure, une couche coalescée 321 s'étendant de façon continue sur toute la surface de la cellule électroluminescente du pixel, et, en partie inférieure, une pluralité de nano-piliers 323 disposés dans les ouvertures 309 du masque 307 et reliant la couche coalescée 321 à la face supérieure des nano-piliers 317 de la couche 311. Dans chaque pixel vert G ou bleu B du dispositif, la couche 319 est une couche sensiblement plane s'étendant de façon continue et sur une épaisseur sensiblement uniforme sur toute la surface de la cellule électroluminescente du pixel.

Le matériau semiconducteur de la couche 319 présente un paramètre de maille différent de celui de la couche 311, et, de préférence, différent de celui de la couche 105. Dans cet exemple, la différence de paramètre de maille entre le matériau de la couche 319 et le matériau de la couche 311 est plus importante qu'entre le matériau de la couche 319 et le matériau de la couche 105. Dans cet exemple, la couche 319 est en nitrure de gallium-indium (InGaN).

Dans les pixels bleus B du dispositif, la couche 311 est faiblement contrainte voire relaxée du côté de sa face supérieure. Du fait de la différence de paramètre de maille relativement élevée entre le matériau de la couche 311 et le matériau de la couche 319, la couche 319 est fortement contrainte du côté de sa face supérieure dans les pixels bleus B du dispositif.

Dans les pixel verts G du dispositif, dans la mesure où la couche 311 est déjà contrainte sur la maille de la couche 105, et où la différence de paramètre de maille entre le matériau de la couche 319 et le matériau de la couche 105 est inférieure à la différence de paramètre de maille entre le matériau de la couche 319 et le matériau de la couche 311, la couche 319 présente, du côté de sa face supérieure, une contrainte moins forte que dans les pixels bleus B du dispositif.

Dans les pixels rouges R du dispositif, du fait de la présence de nanostructurations du côté de la face inférieure de la couche 319, à l'interface avec la couche 311, la couche 319 est relativement faiblement contrainte voire relaxée du côté de sa face supérieure.

Les étapes suivantes du procédé de fabrication du dispositif d'affichage (non détaillées ici) sont par exemple similaires à ce qui a été décrit précédemment en relation avec les figures 3 à 6. Du fait des différences de contraintes de la partie supérieure de la couche 319 entre les pixels rouges R, verts G et bleus B, la concentration d'indium dans chaque couche d'InGaN de la couche active n'est pas la même dans les pixels R, G et B. Plus particulièrement, on obtient une concentration d'indium moins importante dans les pixels bleus B que dans les pixels verts G, et moins importante dans les pixels verts G que dans les pixels rouges R. Ceci permet d'obtenir des gammes de longueurs d'ondes d'émission différentes dans les cellules électroluminescentes des différents types de pixels. Plus particulièrement dans cet exemple, les conditions de croissance de la couche active sont choisies de façon à obtenir une émission majoritairement dans le vert dans les cellules électroluminescentes des pixels G, une émission majoritairement dans le bleu dans les cellules électroluminescentes des pixels B, et une émission majoritairement dans le rouge dans les cellules électroluminescentes des pixels R.

Ainsi, un avantage du procédé de fabrication décrit en relation avec les figures 7 à 11 est qu'il permet de réaliser simultanément, lors d'une même séquence d'étapes d'épitaxie, trois types de cellules électroluminescentes adaptées à émettre respectivement dans trois bandes de longueurs d'ondes distinctes. Ceci permet notamment de se passer totalement d'éléments de conversion de couleur dans le cas d'un dispositif d'affichage à trois couleurs.

La figure 12 est une vue en coupe illustrant des étapes d'un exemple d'un procédé de fabrication d'un dispositif d'affichage électroluminescent multi-couleurs selon un troisième mode de réalisation.

Le mode de réalisation de la figure 12 diffère du mode de réalisation des figures 7 à 11 en ce que, dans le mode de réalisation de la figure 12, le masque 307 est aminci en vis-à-vis des pixels verts G du dispositif, et est entièrement retiré en vis-à-vis des pixels bleus B du dispositif.

Dans le mode de réalisation de la figure 12, les couches 311 et 319 sont en des matériaux semiconducteurs dopés de type N de compositions différentes, présentant des paramètres de maille différents. Plus particulièrement, le matériau de la couche 319 a un paramètre de maille plus important que celui du matériau de la couche 311 qui est luimême plus important que celui de la couche 105. La couche 311 est déposée sur une épaisseur supérieure à l'épaisseur du masque 307 en vis-à-vis des pixels verts G, et inférieure à l'épaisseur du masque 307 en vis-à-vis des pixels rouges R. La couche 319 est déposée sur une épaisseur supérieure à la hauteur des portions des cavités 309 du masque 307 non comblées par les nano-piliers 317 dans les pixels rouges R du dispositif.

Dans cet exemple, la couche 105 est en nitrure de gallium (GaN) et les couches 311 et 319 sont en nitrure de gallium-indium (InGaN). Du fait de la différence de paramètre de maille entre les matériaux des couches 105 et 311, et du fait de l'épaisseur relativement faible de la couche 311 par rapport à la couche 105, la couche 311 est, du côté de sa face supérieure, relativement fortement contrainte en regard des pixels bleus B du dispositif. Dans les pixels verts G et rouges R du dispositif, du fait de la présence des nano-piliers du côté de la face inférieure de la couche 311, la couche 311 est en revanche relativement faiblement contrainte voire relaxée du côté de sa face supérieure.

Dans les pixels bleus B du dispositif, du fait de la contrainte relativement forte de la couche 311 sur la maille de la couche 105, la couche 319 est elle aussi relativement fortement contrainte du côté de sa face supérieure.

Dans les pixels verts G du dispositif, du fait de la différence de paramètre de maille entre le matériau de la couche 311 et le matériau de la couche 319, la couche 319 présente, du côté de sa face supérieure, une contrainte relativement forte, bien que plus faible que la contrainte de la couche 319 dans les pixels bleus B du dispositif.

Dans les pixels rouges R du dispositif, du fait de la présence de nanostructurations du côté de la face inférieure de la couche 319, à l'interface avec la couche 311, la couche 319 est relativement faiblement contrainte (c'est-à-dire moins contrainte que dans les pixels verts G) voire relaxée du côté de sa face supérieure.

Les étapes suivantes du procédé de fabrication du dispositif d'affichage (non détaillées ici) sont par exemple similaires à ce qui a été décrit précédemment. De façon similaire à ce qui a été décrit dans l'exemple des figures 7 à 11, du fait des différences de contrainte en partie supérieure de la couche 319 entre les pixels rouges R, verts G et bleus B, la concentration d'indium dans chaque couche d'InGaN de la couche active n'est pas la même dans les pixels R, G et B. Plus particulièrement, on obtient une concentration d'indium moins importante dans les pixels bleus B que dans les pixels verts G, et moins importante dans les pixels verts G que dans les pixels rouges R. Ceci permet d'obtenir des gammes de longueurs d'ondes d'émission différentes dans les cellules électroluminescentes des différents types de pixels. Plus particulièrement dans cet exemple, les conditions de croissance de la couche active sont choisies de façon à obtenir une émission majoritairement dans le vert dans les cellules électroluminescentes des pixels G, une émission majoritairement dans le bleu dans les cellules électroluminescentes des pixels B, et une émission majoritairement dans le rouge dans les cellules électroluminescentes des pixels R.

La figure 13 est une vue en coupe illustrant des étapes d'un exemple d'un procédé de fabrication d'un dispositif d'affichage électroluminescent multi-couleurs selon un quatrième mode de réalisation.

Le mode de réalisation de la figure 13 diffère des modes de réalisation précédents en ce que, dans le mode de réalisation de la figure 13, les masques 107 ou 307 des exemples précédents sont remplacés par un masque 407. Le masque 407 comprend, en regard des pixels rouges R du dispositif, des ouvertures identiques ou similaires aux ouvertures 109 du masque 107 de la figure 1 ou aux ouvertures 309 du masque 307 de la figure 7. Le masque 407 comprend en outre, en regard des pixels verts G du dispositif, des ouvertures similaires mais présentant des dimensions, par exemple une largeur, plus importantes, et optionnellement un pas plus important, que dans les pixels rouges R. Dans cet exemple, l'épaisseur du masque 407 est sensiblement la même en regard des pixels rouges R et en regard des pixels verts G du dispositif. Le masque 407 est par ailleurs entièrement retiré en regard des pixels bleus B du dispositif.

Dans le mode de réalisation de la figure 13, après la formation du masque 407, une couche 411 d'un matériau semiconducteur dopé de type N est déposée sur la face supérieure de la structure. Lors de cette étape, la croissance épitaxiale s'opère à partir des portions non masquées de la face supérieure de la couche 105. Comme dans les exemples précédents, l'épitaxie est réalisée de manière simultanée dans tous les pixels du dispositif. La couche 411 est déposée sur une épaisseur supérieure à l'épaisseur du masque 407, de façon que, en regard de chaque pixel rouge R et vert G du dispositif, la couche 411 comprenne, en partie supérieure, une couche coalescée s'étendant de façon continue sur toute la surface de la cellule électroluminescente du pixel.

Le matériau semiconducteur de la couche 411 présente un paramètre de maille différent de celui de la couche 105. Dans cet exemple, la couche 105 est en nitrure de gallium (GaN) et la couche 411 est en nitrure de gallium-indium (InGaN) .

Dans les pixels bleus B du dispositif, du fait de la différence de paramètre de maille entre les matériaux des couches 105 et 411, la couche 411 est relativement fortement contrainte du côté de sa face supérieure.

Dans les pixels rouges R du dispositif, du fait de la présence de nanostructurations du côté de la face inférieure de la couche 411, à l'interface avec la couche 105, la couche 411 est relativement faiblement contrainte voire relaxée du côté de sa face supérieure.

Dans les pixels verts G du dispositif, du fait des dimensions plus importantes des nanostructurations en face inférieure de la couche 411, la contrainte de la couche 411 est supérieure à la contrainte de la couche 411 en regard des pixels rouges R, mais inférieure à la contrainte de la couche 411 en regard des pixels bleus B.

Comme dans les exemples de figures 7 à 11 et 12, ceci permet d'obtenir une concentration d'indium moins importante dans la couche active des pixels bleus B que dans la couche active des pixels verts G, et moins importante dans la couche active des pixels verts G que dans la couche active des pixels rouges R, et donc des longueurs d'ondes d'émission différentes dans les cellules électroluminescentes des différents types de pixels. Plus particulièrement dans cet exemple, les conditions de croissance de la couche active sont choisies de façon à obtenir une émission majoritairement dans le vert dans les cellules électroluminescentes des pixels G, une émission majoritairement dans le bleu dans les cellules électroluminescentes des pixels B, et une émission majoritairement dans le rouge dans les cellules électroluminescentes des pixels R.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, les modes de réalisation décrits ne se limitent pas à l'exemple décrit ci-dessus de réalisation des structures d'isolation des cellules électroluminescentes élémentaires des pixels, et des connexions entre les cellules électroluminescentes élémentaires et un circuit de contrôle du dispositif.

De plus, les modes de réalisation décrits ne se limitent pas aux exemples de matériaux et de dimensions indiqués dans la présente description.

En outre, bien que l'on ait décrit ci-dessus des exemples préférentiels de réalisation permettant de réaliser simultanément trois types de pixels adaptés à émettre respectivement dans le bleu, dans le vert et dans le rouge, les modes de réalisation décrits ne se limitent pas à ce cas particulier. En particulier, en jouant sur les compositions des matériaux semiconducteurs et/ou sur les dimensions et/ou l'espacement des ouvertures des masques 107, 307 et/ou 407, on pourra réaliser des cellules électroluminescentes émettant dans d'autres bandes de longueurs d'ondes que celles mentionnées ci-dessus.

Par ailleurs, pour limiter les contraintes et le risque d'arcure du substrat 101 lors de la mise en oeuvre des différentes étapes de dépôt du procédé décrit ci-dessus, des tranchées (non représentées) délimitant les différents pixels du dispositif peuvent être gravées dans la couche semiconductrice 105, par exemple sur toute la hauteur de la couche 105, avant la formation du masque 107, 307 ou 407.

On notera en outre que tous les types de conductivité des couches semiconductrices décrites ci-dessus peuvent être inversés.

## Revendications

1. Dispositif électroluminescent comportant des première et deuxième cellules électroluminescentes adaptées à émettre respectivement dans des première et deuxième gammes de longueurs d'ondes, dans lequel :
- chaque cellule électroluminescente comporte un empilement d'une première couche (105) d'un premier matériau semiconducteur et d'une deuxième couche (111 ; 311 ; 411) d'un deuxième matériau semiconducteur ayant un paramètre de maille différent de celui du premier matériau ;
- dans la première cellule, la première couche (105) est en contact avec la deuxième couche (111 ; 311 ; 411) sur toute la surface de la cellule ; et
- dans la deuxième cellule, un masque (107 ; 307 ; 407) muni d'une pluralité de nano-ouvertures traversantes (109 ; 309) réparties sur toute la surface de la cellule fait interface entre la première couche (105) et la deuxième couche (111 ; 311 ; 411), la deuxième couche (111 ; 311 ; 411) comportant une pluralité de nano-piliers (115 ; 315) du deuxième matériau disposés dans les nano-ouvertures du masque, en contact, par une première face, avec la première couche (105), et une couche coalescée (113 ; 313) du deuxième matériau en contact avec une deuxième face des nano-piliers opposée à la première couche (105), s'étendant sur sensiblement toute la surface de la cellule du côté du masque opposé à la première couche (105),
et dans lequel, dans chaque cellule, la deuxième couche (111 ; 311 ; 411) est surmontée d'une couche active (117) .

2. Dispositif selon la revendication 1, dans lequel, dans chaque cellule, la première couche (105) est dopée d'un premier type de conductivité, et la couche active (117) est surmontée d'une couche semiconductrice (121) dopée du deuxième type de conductivité.

3. Dispositif selon la revendication 1 ou 2, dans lequel la première couche (105) est en nitrure de gallium et la deuxième couche (111) est en nitrure de gallium-indium.

4. Dispositif selon l'une quelconque des revendications 1 à 3, comprenant une troisième cellule électroluminescente identique à la première cellule, dans lequel la troisième cellule est surmontée d'un élément de conversion de longueur d'onde (225), les première et deuxième cellules n'étant pas surmontées d'éléments de conversion de longueur d'onde.

5. Dispositif selon la revendication 1 ou 2, comprenant en outre une troisième cellule électroluminescente adaptée à émettre dans une troisième gamme de longueurs d'ondes, dans lequel :
- la troisième cellule électroluminescente comporte un empilement d'une première couche (105) du premier matériau semiconducteur et d'une deuxième couche (311) du deuxième matériau semiconducteur ;
- dans la troisième cellule, un masque (307) muni d'une pluralité de nano-ouvertures traversantes (309) réparties sur toute la surface de la cellule fait interface entre la première couche (105) et la deuxième couche (311) ;
- l'épaisseur du masque (307) est plus importante dans la troisième cellule que dans la deuxième cellule ; et
- l'épaisseur de la deuxième couche (311) est supérieure à l'épaisseur du masque (307) dans la deuxième cellule et inférieure à l'épaisseur du masque (307) dans la troisième cellule.

6. Dispositif selon la revendication 5, dans lequel chaque cellule comporte en outre une troisième couche (319) d'un troisième matériau semiconducteur surmontant la deuxième couche (311), dans lequel :
- dans chacune des première et deuxième cellules, la troisième couche (319) est en contact avec la deuxième couche (111 ; 311 ; 411) sur sensiblement toute la surface de la cellule ; et
- dans la troisième cellule, la troisième couche (319) comporte une pluralité de nano-piliers (323) disposés dans les nano-ouvertures du masque (307), en contact, par une première face, avec la deuxième couche (311), et une couche coalescée (321) du matériau de la troisième couche en contact avec une deuxième face des nano-piliers (323) opposée à la deuxième couche (311), s'étendant sur sensiblement toute la surface de la cellule du côté du masque (307) opposé à la première couche (105).

7. Dispositif selon la revendication 5 ou 6, dans lequel le troisième matériau présente une différence de paramètre de maille avec le deuxième matériau, la différence de paramètre de maille entre le deuxième matériau et le troisième matériau étant plus importante que la différence de paramètre de maille entre le premier matériau et le troisième matériau.

8. Dispositif selon l'une quelconque des revendications 5 à 7, dans lequel les première (105), deuxième (311) et troisième (319) couches sont respectivement en nitrure de gallium, en nitrure de gallium-aluminium et en nitrure de gallium-indium.

9. Dispositif selon la revendication 5 ou 6, dans lequel les première (105), deuxième (311) et troisième (319) couches sont respectivement en nitrure de gallium, en nitrure de gallium-indium et en nitrure de gallium-indium, les compositions des deuxième (311) et troisième (319) couches de nitrure de gallium-indium étant différentes.

10. Dispositif selon la revendication 1 ou 2, comprenant en outre une troisième cellule électroluminescente adaptée à émettre dans une troisième gamme de longueurs d'ondes, dans lequel :
- la troisième cellule électroluminescente comporte un empilement d'une première couche (105) du premier matériau semiconducteur et d'une deuxième couche (411) du deuxième matériau semiconducteur ;
- dans la troisième cellule, un masque (407) muni d'une pluralité de nano-ouvertures traversantes réparties sur toute la surface de la cellule fait interface entre la première couche (105) et la deuxième couche (311) ; et
- les dimensions des nano-ouvertures du masque (407) sont plus importantes dans la troisième cellule que dans la première cellule.

11. Procédé de fabrication d'un dispositif selon l'une quelconque des revendications 1 à 10, dans lequel les deuxièmes couches (111 ; 311 ; 411) des différentes cellules sont formées simultanément lors d'une même étape d'épitaxie.

12. Procédé de fabrication d'un dispositif selon la revendication 2, dans lequel les couches actives (117) des différentes cellules sont formées simultanément lors d'une même étape d'épitaxie.

## Patentansprüche

1. Lichtemittierende Vorrichtung mit einer ersten und einer zweiten lichtemittierenden Zelle, die so angepasst sind, dass sie jeweils in einem ersten und einem zweiten Wellenlängenbereich emittieren, wobei:
- jede lichtemittierende Zelle einen Stapel aus einer ersten Schicht (105) aus einem ersten Halbleitermaterial und aus einer zweiten Schicht (111; 311; 411) aus einem zweiten Halbleitermaterial mit einem Maschenparameter, der sich von dem des ersten Materials unterscheidet, aufweist;
- in der ersten Zelle die erste Schicht (105) mit der zweiten Schicht (111; 311; 411) über die gesamte Oberfläche der Zelle in Kontakt ist; und
- in der zweiten Zelle eine Maske (107; 307; 407), die mit einer Vielzahl von durchgehenden Nanoöffnungen (109; 309) versehen ist, die regelmäßig über die gesamte Oberfläche der Zelle verteilt sind, eine Grenzfläche zwischen der ersten Schicht (105) und der zweiten Schicht (111; 311; 411) bildet, wobei die zweite Schicht (111; 311; 411) eine Vielzahl von Nanosäulen (115; 315) des zweiten Materials aufweist, die in den Nanoöffnungen der Maske angeordnet sind und über eine erste Oberfläche mit der ersten Schicht (105) in Kontakt stehen, und eine zusammengewachsene Schicht (113; 313) des zweiten Materials, die mit einer zweiten Oberfläche der Nanosäulen gegenüber der ersten Schicht (105) in Kontakt steht und sich im Wesentlichen über die gesamte Oberfläche der Zelle auf der Seite der Maske gegenüber der ersten Schicht (105) erstreckt,
und wobei in jeder Zelle die zweite Schicht (111; 311; 411) mit einer aktiven Schicht (117) bedeckt ist.

2. Vorrichtung nach Anspruch 1, wobei in jeder Zelle die erste Schicht (105) mit einem ersten Leitfähigkeitstyp dotiert ist und die aktive Schicht (117) mit einer dotierten Halbleiterschicht (121) des zweiten Leitfähigkeitstyps bedeckt ist.

3. Vorrichtung nach Anspruch 1 oder 2, wobei die erste Schicht (105) aus Galliumnitrid und die zweite Schicht (111) aus Indiumgalliumnitrid hergestellt ist.

4. Vorrichtung nach einem der Ansprüche 1 bis 3, aufweisend eine dritte lichtemittierende Zelle, die mit der ersten Zelle identisch ist, wobei die dritte Zelle mit einem Wellenlängenwandlerelement (225) versehen ist und die erste und die zweite Zelle nicht mit Wellenlängenwandlerelementen versehen sind.

5. Vorrichtung nach Anspruch 1 oder 2, ferner aufweisend eine dritte lichtemittierende Zelle, die zum Emittieren in einem dritten Wellenlängenbereich geeignet ist, wobei:
- die dritte lichtemittierende Zelle einen Stapel aus einer ersten Schicht (105) des ersten Halbleitermaterials und aus einer zweiten Schicht (311) des zweiten Halbleitermaterials aufweist;
- in der dritten Zelle eine Maske (307), die mit einer Vielzahl von durchgehenden Nanoöffnungen (309) versehen ist, die regelmäßig über die gesamte Oberfläche der Zelle verteilt sind, eine Schnittstelle zwischen der ersten Schicht (105) und der zweiten Schicht (311) bildet;
- die Dicke der Maske (307) in der dritten Zelle größer ist als in der zweiten Zelle; und
- die Dicke der zweiten Schicht (311) größer ist als die Dicke der Maske (307) in der zweiten Zelle und kleiner als die Dicke der Maske (307) in der dritten Zelle.

6. Vorrichtung nach Anspruch 5, wobei jede Zelle ferner eine dritte Schicht (319) aus einem dritten Halbleitermaterial aufweist, die die zweite Schicht (311) überdeckt, wobei:
- in jeder der ersten und zweiten Zellen die dritte Schicht (319) mit der zweiten Schicht (111; 311; 411) über im Wesentlichen die gesamte Oberfläche der Zelle in Kontakt ist; und
- in der ersten Zelle die dritte Schicht (319) eine Vielzahl von Nanosäulen (323) aufweist, die in den Nanoöffnungen der Maske (307) angeordnet sind und über eine erste Oberfläche mit der zweiten Schicht (311) in Kontakt stehen, und eine zusammengewachsene Schicht (321) aus dem Material der dritten Schicht in Kontakt mit einer zweiten Oberfläche der Nanosäulen (323) gegenüber der zweiten Schicht (311) steht und sich im Wesentlichen über die gesamte Oberfläche der Zelle auf der Seite der Maske (307) gegenüber der ersten Schicht (105) erstreckt.

7. Vorrichtung nach Anspruch 5 oder 6, wobei das dritte Material einen Maschenparameterunterschied zu dem zweiten Material aufweist, wobei der Maschenparameterunterschied zwischen dem zweiten Material und dem dritten Material größer ist als der Maschenparameterunterschied zwischen dem ersten Material und dem dritten Material.

8. Vorrichtung nach einem der Ansprüche 5 bis 7, wobei die erste (105), zweite (311) bzw. dritte (319) Schicht jeweils aus Galliumnitrid, Aluminiumgalliumnitrid und Indiumgalliumnitrid bestehen.

9. Vorrichtung nach Anspruch 5 oder 6, wobei die erste (105), zweite (311) bzw. dritte (319) Schicht jeweils aus Galliumnitrid, Indiumgalliumnitrid und Indiumgalliumnitrid bestehen, wobei die Zusammensetzungen der zweiten (311) und dritten (319) Indiumgalliumnitridschicht unterschiedlich sind.

10. Vorrichtung nach Anspruch 1 oder 2, ferner aufweisend eine dritte lichtemittierende Zelle, die zum Emittieren in einem dritten Wellenlängenbereich geeignet ist, wobei:
- die dritte lichtemittierende Zelle einen Stapel aus einer ersten Schicht (105) des ersten Halbleitermaterials und aus einer zweiten Schicht (411) des zweiten Halbleitermaterials aufweist;
- in der dritten Zelle eine Maske (407), die mit einer Vielzahl von durchgehenden Nanoöffnungen versehen ist, die über die gesamte Oberfläche der Zelle verteilt sind, eine Schnittstelle zwischen der ersten Schicht (105) und der zweiten Schicht (311) bildet; und
- die Abmessungen der Nano-Öffnungen der Maske (407) in der dritten Zelle größer sind als in der ersten Zelle.

11. Verfahren zur Herstellung eines Bauelements nach einem der Ansprüche 1 bis 10, wobei die zweiten Schichten (111; 311; 411) der verschiedenen Zellen gleichzeitig während desselben Epitaxieschritts gebildet werden.

12. Verfahren zur Herstellung eines Bauelements nach Anspruch 2, bei dem die aktiven Schichten (117) der verschiedenen Zellen gleichzeitig während desselben Epitaxieschrittes gebildet werden.

## Claims

1. Light-emitting device comprising first and second light-emitting cells adapted to respectively emitting in first and second wavelength ranges, wherein:
- each light-emitting cell comprises a stack of a first layer (105) of a first semiconductor material and of a second layer (111; 311; 411) of a second semiconductor material having a mesh parameter different from that of the first material;
- in the first cell, the first layer (105) is in contact with the second layer (111; 311; 411) across the entire surface of the cell; and
- in the second cell, a mask (107; 307; 407) provided with a plurality of through nano-openings (109; 309) regularly distributed across the entire surface of the cell forms an interface between the first layer (105) and the second layer (111; 311; 411), the second layer (111; 311; 411) comprising a plurality of nanopillars (115; 315) of the second material arranged in the nano-openings of the mask, in contact, by a first surface, with the first layer (105), and a coalesced layer (113; 313) of the second material in contact with a second surface of the nanopillars opposite to the first layer (105), extending across substantially the entire surface of the cell on the side of the mask opposite to the first layer (105),
and wherein, in each cell, the second layer (111; 311; 411) is topped with an active layer (117).

2. Device according to claim 1, wherein, in each cell, the first layer (105) is doped with a first conductivity type, and the active layer (117) is topped with a doped semiconductor layer (121) of the second conductive type.

3. Device according to claim 1 or 2, wherein the first layer (105) is made of gallium nitride and the second layer (111) is made of indium gallium nitride.

4. Device according to any of claims 1 to 3, comprising a third light-emitting cell identical to the first cell, wherein the third cell is topped with a wavelength conversion element (225), and the first and second cells are not topped with wavelength conversion elements.

5. Device according to claim 1 or 2, further comprising a third light-emitting cell adapted to emitting in a third wavelength range, wherein:
- the third light-emitting cell comprises a stack of a first layer (105) of the first semiconductor material and of a second layer (311) of the second semiconductor material;
- in the third cell, a mask (307) provided with a plurality of through nano-openings (309) regularly distributed across the entire surface of the cell forms an interface between the first layer (105) and the second layer (311);
- the thickness of the mask (307) is greater in the third cell than in the second cell; and
- the thickness of the second layer (311) is greater than the thickness of the mask (307) in the second cell and smaller than the thickness of the mask (307) in the third cell.

6. Device according to claim 5, wherein each cell further comprises a third layer (319) of a third semiconductor material topping the second layer (311), wherein:
- in each of the first and second cells, the third layer (319) is in contact with the second layer (111; 311; 411) across substantially the entire surface of the cell; and
- in the first cell, the third layer (319) comprises a plurality of nanopillars (323) arranged in the nano-openings of the mask (307), in contact, by a first surface, with the second layer (311), and a coalesced layer (321) of the material of the third layer in contact with a second surface of the nanopillars (323) opposite to the second layer (311), extending across substantially the entire surface of the cell on the side of the mask (307) opposite to the first layer (105).

7. Device according to claim 5 or 6, wherein the third material has a mesh parameter difference with the second material, the mesh parameter difference between the second material and the third material being greater than the mesh parameter difference between the first material and the third material.

8. Device according to any of claims 5 to 7, wherein the first (105), second (311), and third (319) layers are respectively made of gallium nitride, aluminum gallium nitride, and indium gallium nitride.

9. Device according to claim 5 or 6, wherein the first (105), second (311), and third (319) layers are respectively made of gallium nitride, indium gallium nitride, and indium gallium nitride, the compositions of the second (311) and third (319) indium gallium nitride layers being different.

10. Device according to claim 1 or 2, further comprising a third light-emitting cell adapted to emitting in a third wavelength range, wherein:
- the third light-emitting cell comprises a stack of a first layer (105) of the first semiconductor material and of a second layer (411) of the second semiconductor material;
- in the third cell, a mask (407) provided with a plurality of through nano-openings distributed across the entire surface of the cell forms an interface between the first layer (105) and the second layer (311); and
- the dimensions of the nano-openings of the mask (407) are greater in the third cell than in the first cell.

11. Method of manufacturing a device according to any of claims 1 to 10, wherein the second layers (111; 311; 411) of the different cells are simultaneously formed during a same epitaxy step.

12. Method of manufacturing a device according to claim 2, wherein the active layers (117) of the different cells are simultaneously formed during a same epitaxy step.
